# EUROPÄISCHE PATENTSCHRIFT

(11) **EP 4 482 708 B1**
(45) Veröffentlichungstag und Bekanntmachung des Hinweises auf die Patenterteilung: **12.11.2025**
(21) Anmeldenummer: 23702077.1
(22) Anmeldetag: 24.01.2023
(51) Int. Cl.: B60N 2/02, B60N 2/58, B60N 2/70

(54) **SITZBEZUG MIT EINEM STEUERUNGSELEMENT, SITZELEMENT FÜR EIN KRAFTFAHRZEUG SOWIE KRAFTFAHRZEUG**
SEAT COVER WITH A CONTROL ELEMENT, SEAT FOR AN AUTOMOTIVE VEHICLE AND AUTOMOTIVE VEHICLE
HOUSSE POUR SIÈGE AVEC ÉLÉMENT DE COMMANDE, ASSISE DE SIÈGE POUR VÉHICULE AUTOMOBILE ET VÉHICULE AUTOMOBILE

(30) Priorität: 21.02.2022 DE 102022104005
(43) Veröffentlichungstag der Anmeldung: 01.01.2025
(73) Patentinhaber: Bayerische Motoren Werke Aktiengesellschaft, 80809 München (DE)
(72) Erfinder: OESTERREICH, Matthias, 80639 Muenchen (DE)
(86) Internationale Anmeldenummer: PCT/EP2023/051602
(87) Internationale Veröffentlichungsnummer: WO 2023/156153

(56) Entgegenhaltungen:
- WO-A1-2004/080752
- US-A1- 2011 241 442
- US-A1- 2015 108 818
- US-A1- 2019 344 689

## Beschreibung

Die vorliegende Erfindung betrifft einen Sitzbezug für ein Sitzelement eines Kraftfahrzeugs, wobei der Sitzbezug ein elektronisches Steuerungselement aufweist. Ferner betrifft die Erfindung ein Sitzelement für ein solches Kraftfahrzeug, wobei das Sitzelement einen Sitzkörper aufweist, der mit einem solchen Sitzbezug bezogen ist. Bei dem Kraftfahrzeug handelt es sich insbesondere um ein solches Kraftfahrzeug, das eine Sattelsitzanlage aufweist, also zum Beispiel um ein Kraftrad, ein ATV (All Terrain Vehicle bzw. "Quad") etc. Mittels des Steuerungselements ist eine Fahrzeugfunktion oder eine Vielzahl von Fahrzeugfunktionen steuerbar, indem ein (menschlicher) Nutzer des Sitzelements, beispielsweise ein Fahrer oder Beifahrer des mit dem Sitzelement ausgerüsteten Kraftfahrzeugs, eine Betätigungshandlung an/mit dem Steuerungselement vornimmt. Zudem betrifft die Erfindung ein Kraftfahrzeug, insbesondere ein Kraftrad, mit einem solchen Sitzelement.

Sitzheizungen für Kraftfahrzeuge sind bekannt, etwa aus der DE 196 39 750 A1 oder aus der DE 10 2004 034 675 A1. Im Motorradsektor kann beispielsweise eine Fahrersitzheizung durch den Fahrer mittels eines im Bereich des Motorradlenkers angeordneten Bedienelements, etwa eines Sitzheizungsschalters, und/oder mittels einer entsprechenden Steuerungsbefehleingabe in ein auswahlmenübasiertes Fahrzeugbedienungssystem im Bereich einer Instrumentenkombination ein-/ausgeschaltet, umgeschaltet und/oder geregelt werden. Solche Bedienelemente sind zum Beispiel aus der DE 10 2017 212 064 A1 oder aus der DE 10 2016 203 194 A1 bekannt. Es gibt Motorradmodelle, bei denen eine Soziussitzheizung über kein eigens zugeordnetes Bedienelement verfügt, sondern das Bedienelement der Soziussitzheizung im Bereich des Motorradlenkers sitzt, sodass im Fahrbetrieb lediglich der Fahrer darauf Zugriff hat. Der Sozius hat also in diesem Fall keine Möglichkeit, die Soziussitzheizung zu bedienen, ohne den Fahrer ablenken zu müssen. Denn der Sozius muss den Fahrer auf sich aufmerksam machen, ihm dann den Wunsch klarmachen, dass die Sitzheizung bedient werden soll, sodass dann der Fahrer die Soziussitzheizung verstellen kann. Ferner ist es bekannt, in einem Zugriffsbereich des Sozius ein Bedienelement zum Steuern der Soziussitzheizung anzuordnen. Bei einem herkömmlichen Sitzheizungsbedienelement kann es sich zum Beispiel um einen mechanischen Kippschalter handeln, welcher durch seine Raststellungen die Schalterstellung und damit die Heizstufe charakterisiert.

Üblicherweise werden solche Sitzheizungsbedienelemente mittels eines Bedienelementträgers mit einer Sitzwanne des entsprechenden Sitzes verbunden, wobei ein Betätigungselement des Bedienelements von einem Bezug des Sitzes hervorspringt und diesen durchdringt. Dadurch ist zwischen dem Bedienelement und dem Bezug ein Spalt vorhanden, wobei heutzutage versucht wird, mittels zusätzlicher Blenden diesen Spalt zu verschließen bzw. zu bedecken. Solche Blenden fügen sich nur schlecht ästhetisch in eine Gesamterscheinung des Sitzes und infolgedessen des entsprechenden Fahrzeugs ein. Ferner weist ein solcher Aufbau besonders viele Teile auf, die miteinander in Verbindung zu bringen sind, um den Sitz herzustellen. Weiter kann es dazu kommen, dass in unerwünschter Weise eine Flüssigkeit, etwa Regenwasser, durch den Spalt in das Innere des Sitzes eindringt bzw. hineinläuft und dort das Fahrzeug beschädigt. Darüber hinaus ist der Sitz zumindest an der Stelle des Bedienelements bzw. der Blende härter, sodass es dazu kommen kann, dass ein Nutzer des Sitzes in eine unbequeme Sitzposition gezwungen wird, um zu vermeiden, dass er mit einem Körperteil an die Blende stößt.

Die WO 2004/080752 A1 beschreibt eine Bedieneinrichtung, die in flexible oder teilflexible Polstermöbel und Fahrzeuginneneinrichtungen integriert werden kann, ohne die mechanischen Eigenschaften zu beeinträchtigen.

Die US 2019 344689 A1 beschreibt eine Fahrzeuginnenausstattung mit einer Lederabdeckung, die eine elektrisch leitfähige Beschichtung aufweist. Diese Beschichtung kann als Kabelbaum, elektrischer Widerstandsheizer, berührungsempfindliche Steuerung oder elektrolumineszente bzw. elektrochrome Beleuchtung fungieren. Dadurch wird die Lederabdeckung multifunktional und verbessert die elektrische Effizienz sowie das Design der Fahrzeuginnenausstattung.

Die US 2015 0108818 A1 beschreibt eine elektrische Sitzverstellung, bei der Bedienungseinheiten in beweglichen Teilen eines Fahrzeugsitzes integriert sind. Diese Einheiten bestehen aus einem Paar Elektroden und einer dazwischen angeordneten, komprimierbaren dielektrischen Schicht, die durch Druck des Bedieners verformt wird, wodurch die Kapazität zwischen den Elektroden verändert wird.

Die US 2011 0241442 A1 beschreibt einen kapazitiven Domschalter, der eine kapazitive Sensorik verwendet, um die Betätigung des Schalters durch den Benutzer zu erkennen, wobei die elektrischen Komponenten vor Verunreinigungen geschützt sind.

Es ist die Aufgabe der Erfindung, eine Möglichkeit zu schaffen, ein Bedienelement zum Steuern einer Fahrzeugfunktion besonders effizient in eine Sitzanlage des Fahrzeugs zu integrieren.

Diese Aufgabe wird durch einen Sitzbezug für ein Sitzelement nach dem unabhängigen Anspruch 1 gelöst.

Weitere mögliche Ausgestaltungen der Erfindung sind in den Unteransprüchen definiert.

Erfindungsgemäß wird ein Sitzbezug für ein Sitzelement vorgeschlagen. In bestimmungemäßer Einbaulage weist das Sitzelement den Sitzbezug auf, indem ein Sitzkörper des Sitzelements mit dem Sitzbezug bezogen oder bespannt ist. Dabei ist das Sitzelement zum Einsatz in/an einem Kraftfahrzeug ausgebildet. Demnach weist das Kraftfahrzeug, wenn es fertig bzw. einsatzbereit hergestellt ist, den Sitzbezug auf, indem das Kraftfahrzeug das Sitzelement aufweist. Bei dem Kraftfahrzeug handelt es sich insbesondere um ein Kraftfahrzeug mit einer Sattelsitzanlage, etwa um ein Kraftrad bzw. Motorrad oder um ein sonstiges (eventuell unmotorisiertes) Fahrzeug, das eine solche Sattelsitzanlage aufweist. Zudem ist der Sitzbezug bzw. das den Sitzbezug aufweisende Sitzelement zum Einsatz in/an anderen Fahrzeugen, wie Kraftwagen, geeignet.

Der Sitzbezug umfasst ein elektronisches Steuerungselement, bei welchem es sich um ein Bedienelement handelt, mittels dessen ein Nutzer, zum Beispiel Fahrer oder Beifahrer/Sozius, des Kraftfahrzeugs/Motorrads eine Fahrzeugfunktion oder eine Vielzahl von Fahrzeugfunktionen steuern kann. Das bedeutet, dass das elektronische Steuerungselement dazu ausgebildet (das heißt angeordnet und eingerichtet) ist, mit einer Steuereinrichtung des Kraftfahrzeugs zum Steuern einer Fahrzeugfunktion gekoppelt zu werden. Das elektronische Steuerungselement, das heißt der Sitzbezug, weist eine berührungssensitive Sensoroberfläche - ähnlich der eines Touchpads - auf. Bei der berührungssensitiven Sensoroberfläche handelt es sich also zum Beispiel um eine resistive und/oder kapazitive Sensoroberfläche.

Der Sitzbezug, dessen gesamte Außenoberfläche in bestimmungsgemäßer Einbaulage unter anderem eine Sitzoberfläche bildet, auf der der Nutzer sich setzen kann, weist einen Betätigungsanteil auf. Die gesamte Außenoberfläche des Sitzbezugs ist also aus einem ersten Außenoberflächenanteil des Betätigungsanteils und einem weiteren bzw. zweiten Außenoberflächenanteil eines von dem Betätigungsanteil verschiedenen bzw. abgegrenzten Nichtbetätigungsanteils gebildet. Dabei ist dem Betätigungsanteil bzw. dessen Außenoberflächenanteil zumindest teilweise die Sensoroberfläche des Steuerungselements funktional zugeordnet. Somit ist das Steuerungselement dazu ausgebildet, aufgrund einer Betätigungshandlung, die ein Nutzer auf/an der Außenoberfläche des Sitzbezugs, nämlich an oder in dem Außenoberflächenanteil des vorgegebenen Betätigungsanteils, vornimmt - wodurch die berührungssensitive Sensoroberfläche betätigt wird -, ein Steuersignal bereitzustellen. Der Nutzer betätigt also die Sensoroberfläche des Steuerungselements, indem er die Außenoberfläche des Sitzbezugs im Betätigungsanteil zum Beispiel berührt, antippt etc. Basierend auf der Betätigungshandlung bzw. basierend auf der Betätigung der Sensoroberfläche wird das Steuersignal bereitgestellt. Dabei sind die Sensoroberfläche und der Betätigungsanteil so sensitiv ausgebildet, dass ein erfolgreiches Betätigen der Sensoroberfläche selbst dann erfolgt, wenn ein Nutzer mit einem behandschuhten Finger die Sensoroberfläche oder den Außenoberflächenanteil des Betätigungsanteils berührt bzw. die Betätigungshandlung an der Sensoroberfläche oder am Außenoberflächenanteil des Betätigungsanteils ausführt.

Für das Kraftfahrzeug gilt, dass dessen Steuereinrichtung zum Akzeptieren des mittels des Steuerungselements bereitgestellten Steuersignals konfiguriert ist. Wenn das Kraftfahrzeug fertig bzw. einsatzbereit hergestellt ist, sind die Steuereinrichtung und das elektronische Steuerungselement also zumindest insoweit miteinander gekoppelt oder koppelbar, dass das Vornehmen der Betätigungshandlung ein Steuern einer Fahrzeugfunktion nach sich zieht.

Der Betätigungsanteil und ein restlicher Anteil des Sitzbezugs - insbesondere der Betätigungsanteil und der direkt dazu benachbarte bzw. direkt daran angrenzende Nichtbetätigungsanteil - sind spaltfrei miteinander verbunden. Dabei können sowohl der Betätigungsanteil als auch der Nichtbetätigungsanteil jeweils biegeschlaff ausgebildet sein. Zumindest der Nichtbetätigungsanteil des Sitzbezugs kann ein- oder mehrteilig und/oder ein- oder mehrschichtig aufgebaut sein. Dabei sind die einzelnen Teile bzw.

Schichten - sofern vorhanden - kraft-, form- und/oder stoffschlüssig miteinander verbunden, beispielsweise miteinander vernäht, vernietet, verschraubt, verklebt etc. Für eine äußerste Schicht des Sitzbezugs kommt als Material zum Beispiel ein Leder oder ein lederartiges Material oder ein sonstiger Sitzbezugstoff infrage.

Da der Sitzbezug durch den Betätigungsanteil und den damit spaltfrei verbundenen restlichen Anteil bzw. Nichtbetätigungsanteil gebildet ist, findet sich außen an dem Sitzbezug, das heißt an der gesamten Außenoberfläche, und infolgedessen außen an dem Sitzelement kein Spalt. Der Sitzbezug ist durchgängig über den Sitzkörper (und über ein eventuell vorhandenes Polstermaterial) gelegt oder gespannt, wodurch sich eine geschlossene Außenoberfläche des Sitzelements ergibt. So fügt sich das Steuerungselement besonders ästhetisch in das Gesamtbild des Sitzelements ein. Somit kann auf das Herstellen einer Blende (wie bei herkömmlichen Bedienelementen) verzichtet werden, was sich in einer vorteilhaft besonders einfachen Struktur des Sitzelements und in einer besonders masseeffizienten, da bauteilarmen, Konstruktion des Sitzelements niederschlägt. Zudem kann beim Herstellen des Sitzelements auf einige Prozessschritte verzichtet werden, zum Beispiel auf ein Befestigen eines Bedienelements an der Blende, ein Handhaben und Ausrichten der Blende an einem herkömmlichen Trägerelement, ein Befestigen der Blende an diesem Trägerelement etc. Entsprechende Verbindungsmittel, wie Klebemittel, Schraubelemente und dergleichen, entfallen ebenso, weshalb das Sitzelement und das entsprechend ausgestattete Kraftfahrzeug, insbesondere Kraftrad, ökologisch besonders günstig hergestellt werden kann. Ferner ist durch die spaltfreie Außenoberfläche gewährleistet, dass keine Flüssigkeit, zum Beispiel Regenwasser, in das Innere des Sitzelements eindringt.

Das Steuerungselement ist insbesondere frei von mechanisch bewegbaren Elementen ausgebildet, die zum Betätigen der Sensoroberfläche zwingend bewegt werden müssten. Damit unterscheidet sich das Steuerungselement somit von herkömmlichen Tastern, Schaltern etc. Durch die bewegungsmechanikfreie Struktur des Steuerungselements wird Störgeräuschen vorgebeugt und folglich zu einer besonders vorteilhaften NVH-Qualität (NVH: Noise, Vibrations, Harshness - Geräusche, Vibrationen, Rauheit) beigetragen. Zudem ergibt sich eine besonders einfache und in vorteilhafter Weise besonders bauteilarme Struktur des Steuerungselements, wodurch eine bauraumeffiziente Integration des Steuerungselements in das Sitzelement unterstützt wird.

Elektrische Leiterelemente, wie Energieversorgungskabel, Signalkabel etc., mittels dessen das Steuerungselement in bestimmungsgemäßer Einbaulage mit der Steuereinrichtung des Kraftfahrzeugs verbunden ist, sind in den Sitzbezug, insbesondere von außen durch den Nutzer nicht ohne weitere Hilfsmittel optisch erkennbar und nicht ertastbar, integriert. Beispielsweise sind die Leiterelemente auf einem flachen biegeelastischen Leitungsträger aufgebracht (zum Beispiel aufgedampft, aufgedruckt etc.), wobei der Leitungsträger mit dem Sitzbezug vernäht ist oder auf diesen aufgeklebt ist. Ferner ist es denkbar, dass die Leiterelemente direkt in ein Material des Sitzbezugs eingearbeitet sind, zum Beispiel eingewebt, eingenäht etc. Die Leiterelemente können des Weiteren zwischen zwei Materiallagen des Sitzbezugs angeordnet sein.

In einer alternativen Ausgestaltung kann vorgesehen sein, dass eines oder mehr der elektrischen Leiterelemente in bestimmungsgemäßer Einbaulage sich durch den Sitzbezug hindurch an dessen Außenoberfläche optisch erkennbar abzeichnet/abzeichnen oder zumindest durch die Außenoberfläche hindurch erstastbar ist/sind. Das jeweilige an der Außenoberfläche sichtbare/ertastbare Leiterelement kann sich beispielsweise als ein Designelement, etwa als ein Relief, an der Außenoberfläche abzeichnen oder direkt auf der Außenoberfläche angeordnet sein. Es ist insbesondere denkbar, dass das entsprechende Leiterelement auf die Außenoberfläche außenseitig aufgebracht, zum Beispiel aufgedruckt oder aufgedampft ist oder außenseitig mit der Außenoberfläche vernäht ist etc. In diesem Fall kann eine Markierungsanordnung, die weitere unten noch genauer beschrieben wird, das jeweilige an der Außenoberfläche sichtbare/ertastbare Leiterelement aufweisen. Anders ausgedrückt: das jeweilige an der Außenoberfläche sichtbare/ertastbare Leiterelement kann als ein Markierungselement der Markierungsanordnung fungieren.

Erfindungsgemäß weist der Sitzbezug eine Sitzbezugsschicht auf, durch deren Oberseite der Außenoberflächenanteil des Betätigungsanteils des Sitzbezugs gebildet ist. Dadurch weist die Sitzbezugsschicht den Betätigungsanteil auf. Die Sensoroberfläche des Steuerungselements ist dabei an einer der Oberseite bzw. Außenoberfläche der Sitzbezugsschicht gegenüberliegenden Rückseite der Sitzbezugsschicht gegenüber dem Betätigungsanteil angeordnet, insbesondere befestigt. In bestimmungsgemäßer Einbaulage des Steuerungselements ist dessen Sensoroberfläche von der Sitzbezugsschicht bedeckt, quasi unter der Sitzbezugsschicht angeordnet. Beispielsweise ist die Sensoroberfläche mit der Sitzbezugsschicht überspannt. Berührt nun der Nutzer die Oberseite der Sitzbezugsschicht, drückt er sie zum Beispiel ein, wird dadurch die unter der Sitzbezugsschicht angeordnete (resistive) Sensoroberfläche betätigt. Um ein Betätigen der Sensoroberfläche durch die Sitzbezugsschicht hindurch selbst dann zu gewährleisten, wenn die Sensoroberfläche als eine kapazitive Sensoroberfläche ausgebildet ist, ist des Weiteren vorgesehen, dass die Sitzbezugsschicht ganz oder zumindest im Betätigungsbereich elektrisch leitfähig ausgebildet ist. Hierzu kann die Sitzbezugsschicht vollständig aus einem elektrisch leitfähigen Material gebildet sein oder zumindest Materialanteile, zum Beispiel Fäden oder Fasern, aufweisen, die elektrisch leitfähig sind. Durch das elektrisch leitfähige Material bzw. durch die elektrisch leitfähigen Materialanteile ist eine elektrische Verbindung zwischen der Oberseite und der Rückseite der Sitzbezugsschicht hergestellt, sodass die kapazitive Sensoroberfläche besonders effizient durch den Nutzer betätigt werden kann. Egal ob die Sitzbezugsschicht elektrisch leitend oder elektrisch isolierend ausgebildet ist, ergibt sich eine spaltfrei geschlossene, insbesondere nahtlose Außenoberfläche des Sitzbezugs.

In noch einer weiteren Ausführungsform des Sitzbezugs umfasst dieser eine positionell mit dem Betätigungsanteil korrespondierende Markierungsanordnung. Die Markierungsanordnung ist insbesondere an/auf der Außenoberfläche des Sitzbezugs (oder gegebenenfalls an/auf der Oberseite der Sitzbezugsschicht) ausgebildet bzw. angeordnet und dort kraft-, form- und/oder stoffschlüssig fixiert, zum Beispiel vernäht, verklebt, verschweißt, verschraubt, vernietet etc. Alternativ oder zusätzlich ist es denkbar, dass die Außenoberfläche des Sitzbezugs (bzw. Oberseite der Sitzbezugsschicht) zumindest teilweise durch die Markierungsanordnung gebildet ist. Demnach kann es sich bei der Markierungsanordnung um einen integralen Bestandteil des Sitzbezugs oder der Sitzbezugsschicht handeln. Die Markierungsanordnung weist eines oder mehr der folgenden Markierungselemente auf:
- eine Farbmarkierung,
- eine Prägung,
- ein Stickgebilde,
- ein Nähgebilde,
- ein Markierungsbezugelement,
- eine Plakette,
- ein Leuchtelement.

Da die Markierungsanordnung und der Betätigungsanteil positionell, das heißt hinsichtlich ihrer jeweiligen Lage, miteinander korrespondieren, ist es für den Nutzer besonders einfach, die Sensoroberfläche aufzufinden und die entsprechende(n) Fahrzeugfunktion(en) zu schalten bzw. zu steuern. Hierzu kann durch das wenigstens eine Markierungselement ein die entsprechende(n) Fahrzeugfunktion(en) charakterisierendes Symbol bereitgestellt sein, etwa ein Symbol für eine Heizungs-, insbesondere Sitzheizungsfunktion etc. Soweit die Markierungsanordnung den Betätigungsanteil außenseitig bedeckt, ist zumindest der den Betätigungsanteil bedeckende Anteil der Markierungsanordnung so ausgebildet, dass unter einem Berühren dieses Anteils der Markierungsanordnung die Sensoroberfläche durch den den Außenoberflächenanteil des Betätigungsanteils bedeckenden Anteil der Markierungsanordnung hindurch betätigbar ist.

In einer weiteren möglichen Ausgestaltung ist durch die Markierungsanordnung ein Betätigungspfad an der Außenoberfläche, insbesondere an dem Außenoberflächenanteil des Betätigungsanteils, gekennzeichnet, das heißt hervorgehoben oder markiert. Es kann beispielsweise vorgesehen sein, dass das Steuerungselement dazu ausgebildet ist, eine mehrstufig oder stufenlos verstellbare Fahrzeugfunktion zu steuern, zum Beispiel die Sitzheizungsfunktion, eine dimmbare Beleuchtungsfunktion, eine Gebläsefunktion etc. Als Steuerungsgeste zum Verstellen von entsprechenden Intensitäten/Stufen einer solchen Funktion kann ein Entlangfahren oder Entlangstreichen mit einer Fingerspitze an dem länglichen Betätigungspfad vorgesehen oder vorgegeben sein. Damit der Nutzer diesen länglichen Betätigungspfad besonders aufwandsarm und unter besonders wenig Ablenkung schnell auffinden kann, ist eine positionelle Lage des Betätigungspfads durch die Markierungsanordnung markiert. Zudem kann die Markierungsanordnung entlang des gesamten Betätigungspfads angeordnet sein, sodass der Nutzer den Betätigungspfad einfach von nicht mit dem Steuerungselement zusammenwirkenden Anteilen der Außenoberfläche unterscheiden kann. Um dem Nutzer die Möglichkeit zu geben, ohne Blickwendung den Betätigungspfad besonders aufwandsarm ertasten zu können, kann die positionelle Lage des Betätigungspfads durch haptisch wirksame (erhabene und/oder versenkte) Markierungselemente gekennzeichnet sein.

Gemäß einer Weiterbildung des Sitzbezugs weist dieser eine Kontrolleinrichtung auf, die dazu ausgebildet ist, mittels des Betätigungsanteils bzw. über den Betätigungsanteil dem Nutzer ein Kontrollsignal bereitzustellen, das eine erfolgreiche Betätigung der Sensoroberfläche charakterisiert. So erhält der Nutzer eine Rückmeldung, sofern er die Betätigungshandlung erfolgreich vorgenommen hat. Hierzu kann vorgesehen sein, dass die Kontrolleinrichtung und das Steuerungselement miteinander gekoppelt oder koppelbar sind, wobei das Steuerungselement bei erfolgreicher Betätigung der Sensoroberfläche die Kontrolleinrichtung ansteuert, woraufhin diese das Kontrollsignal ausgibt. Das Kontrollsignal kann haptischer, optischer und/oder akustischer Natur sein. Demnach weist die Kontrolleinrichtung eine Ausgabeeinheit auf, die zum Ausgeben bzw. Bereitstellen des Kontrollsignals ausgebildet ist, etwa einen Lautsprecher, ein Display etc.

In weiterer Ausgestaltung umfasst die Kontrolleinrichtung ein Federelement, das unter einem Betätigen der Sensoroberfläche sich schlagartig verformt und dabei ein Kontrollgeräusch abgibt und so eine haptische Rückmeldung bereitstellt. Das Federelement ist hierzu als ein Federstreifen, zum Beispiel aus einem Federstahl, hergestellt und so geprägt, dass es aus einem stabilen Ruhezustand über einen metastabilen Zustand in einen instabilen Endzustand gebogen werden kann. Durch Krafteinwirkung, beispielsweise Drücken, wird der Federstreifen also aus dem stabilen Ruhezustand verbogen, bis er den metastabilen Zustand erreicht. Wird der Federstreifen über den metastabilen Zustand hinaus überdrückt, erzeugt er unter einem schlagartigen Umspringen in den instabilen Endzustand ein Knackgeräusch. Lässt die Kraft wieder nach, springt das Federelement automatisch aus dem instabilen Endzustand über den metastabilen Zustand wieder in den stabilen Ruhezustand zurück, wodurch erneut das Knackgeräusch erzeugt wird. Das Federelement ist insbesondere vor der Sensoroberfläche angeordnet, sodass der Nutzer das Federelement bzw. den Federstreifen in den instabilen Endzustand verbiegen muss, um die Sensoroberfläche zu bedienen. So erhält der Nutzer zum einen durch das Knackgeräusch eine akustische Bestätigung darüber, dass er die Sensoroberfläche betätigt hat. Zum anderen erfährt der Nutzer eine haptische Rückmeldung beim erfolgreichen Betätigen der Sensoroberfläche, da das Umspringen des Federelements aus dessen metastabilen Zustand in dessen instabilen Endzustand deutlich spürbar ist.

Eine weitere Möglichkeit, das Federelement zum Bereitstellen des Kontrollgeräuschs zu realisieren, besteht darin, einen mit Hohlräumen ("Blasen") durchzogenen und reversibel elastisch verformbaren Materialkörper, etwa aus einem Elastomer, bereitzustellen. Dabei fungieren die Wandungen der Hohlräume als ein jeweiliges Federelement. Bei einem Komprimieren des Materialkörpers werden die Wandungen der Hohlräume unter Abgabe des Knackgeräusches verformt - analog zu der obigen Beschreibung.

Das Federelement kommt ohne weitere elektronische Bauteile aus, hat eine besonders einfach realisierbare Konstruktion und ist besonders kompakt. Es lässt sich daher besonders effizient in den Sitzbezug integrieren. Ferner bietet es eine vorteilhafte Möglichkeit, um dem Nutzer eine akustische und eine optische Rückmeldung über die Betätigung der Sensoroberfläche bereitzustellen.

Die Kontrolleinrichtung kann in weiterer Ausgestaltung eine Leuchteinheit aufweisen, die dazu ausgebildet ist, basierend auf einem Betätigen der Sensoroberfläche ein Kontrolllichtsignal auszugeben und/oder zu ändern. Hierzu kann die Leuchteinheit das Leuchtelement aufweisen. Alternativ oder zusätzlich zu dem Leuchtelement kann die Leuchteinheit wenigstens ein weiteres Leuchtmittel aufweisen, etwa eine LED; leuchtende, beleuchtbare Fasern, Fäden oder Faser- bzw. Fadenstränge; Lichtleitelemente etc. Betätigt der Nutzer die Sensoroberfläche wird über die Kontrolleinrichtung, das heißt über die Leuchteinheit, zum Beispiel ein erstes Kontrolllichtsignal ausgegeben, durch welches dem Nutzer vermittelt wird, dass er die Sensoroberfläche erfolgreich betätigt hat. Des Weiteren kann vorgesehen sein, dass ein vor dem Betätigen bereits Licht emittierendes Leuchtmittel der Leuchteinheit aufgrund der erfolgreichen Betätigung der Sensoroberfläche hinsichtlich Leuchtintensität und/oder Leuchtfarbe verändert wird. Dies ist insbesondere für den Fall vorgesehen, in welchem es sich bei dem Leuchtmittel der Kontrolleinrichtung um das Leuchtelement der Markierungsanordnung handelt. Der Nutzer kann unter Nutzung der Leuchteinheit besonders schnell und einfach erkennen, ob die entsprechende Fahrzeugfunktion aktiviert oder deaktiviert ist. Unter Auswertung der Änderung des Kontrolllichtsignals kann der Nutzer zudem einfach und aufwandsarm erkennen, auf welcher Stufe/Intensität die Fahrzeugfunktion aktuell betrieben wird. Die Leuchteinheit ist insbesondere in einem Bereich des Sitzbezugs angebracht, den der Nutzer besonders einfach erkennen bzw. auffinden kann. Dann wird der Nutzer beim Bedienen/Steuern der Fahrzeugfunktion bzw. zum Kontrollieren eines Schalt- oder Stufenzustands der Fahrzeugfunktion in vorteilhafter Weise kaum von seinen Fahraufgaben abgelenkt.

Die Erfindung betrifft zudem ein Sitzelement für das Kraftfahrzeug, wobei das Sitzelement einen Sitzkörper und einen gemäß der vorstehenden Beschreibung ausgebildeten Sitzbezug aufweist. Dabei ist der Sitzkörper mit dem Sitzbezug bezogen, wodurch das Sitzelement an der Außenoberfläche des Sitzbezugs, den Betätigungsanteil zum Betätigen der Sensoroberfläche des Steuerungselements aufweist.

Überdies betrifft die Erfindung ein Kraftfahrzeug, insbesondere Kraftrad, das mit einem gemäß der vorstehenden Beschreibung ausgebildeten Sitzelement ausgerüstet ist. Bei dem Kraftfahrzeug bzw. Kraftrad/Motorrad sind das elektronische Steuerelement und die Steuereinrichtung des Kraftfahrzeugs zum Steuern der Fahrzeugfunktion oder Fahrzeugfunktionen miteinander kabellos oder kabelgebunden - gegebenenfalls mittels eines Bordnetzes des Kraftfahrzeugs - gekoppelt oder koppelbar.

Die Außenoberfläche des Sitzbezugs bzw. des Sitzelements weist generell eine Doppelfunktionalität auf, dient nämlich einerseits dazu, Elemente des Sitzkörpers (Polsterung, formstabile Träger, Befestigungselemente etc.) vor Witterungseinflüssen zu schützen. Andererseits fungiert die Außenoberfläche - nämlich mittels des Betätigungsanteils - als Eingabe- bzw. Bedienelement zum Steuern der Fahrzeugfunktion(en). Des Weiteren kann der Sitzbezug selbst eine Polsterung aufweisen.

Zudem betrifft die Erfindung ein Verfahren zum Steuern zumindest einer Fahrzeugfunktion eines Kraftfahrzeugs mittels einer gemäß der vorstehenden Beschreibung ausgebildeten Sitzbezugs. Bei dem Verfahren wird durch einen Nutzer an dem Außenoberflächenanteil des vorgegebenen Betätigungsanteils des Sitzbezugs eine Betätigungshandlung ausgeführt bzw. vorgenommen, wodurch die berührungssensitive Sensoroberfläche betätigt wird. Basierend auf dem Betätigen der Sensoroberfläche wird einer Steuereinrichtung des Kraftfahrzeugs durch das Steuerungselement ein Steuersignal bereitgestellt, anhand dessen die Fahrzeugfunktion gesteuert wird. Bei der Betätigungshandlung handelt es sich insbesondere um eine Touch-Eingabe, zum Beispiel um ein Einfach- oder Mehrfachantippen, um eine Wisch- bzw. Streichgeste etc. Die Betätigungshandlung bzw. Touch-Eingabe kann dabei mittels eines Fingers oder mittels mehrerer Finger gleichzeitig eingegeben werden. Insbesondere ist vorgesehen, dass je nach Betätigungshandlung unterschiedliche Fahrzeugfunktionen gesteuert/geregelt werden und/oder dass je nach Betätigungshandlung die Fahrzeugfunktion unterschiedlich gesteuert/geregelt wird.

Die Zeichnung zeigt in:
- Fig. 1: eine schematische und geschnittene Ansicht eines Sitzelements, das einen nicht zur beanspruchten Erfindung gehörenden Sitzbezug mit einem elektronischen Steuerungselement aufweist;
- Fig. 2: eine schematische und geschnittene Ansicht eines Sitzelements, mit einem erfindungsgemäßen Sitzbezug welcher eine Sitzbezugsschicht aufweist, mit der eine Sensoroberfläche des Steuerungselements bedeckt ist; und
- Fig. 3: eine schematische und geschnittene Ansicht eines Sitzelements, wobei das Steuerungselement teilweise in eine Polsterung eingebettet ist.

Im Folgenden werden ein Sitzbezug 1, ein den Sitzbezug 1 aufweisendes Sitzelement 2 sowie ein Kraftfahrzeug (nicht dargestellt), das insbesondere eine Sattelsitzanlage aufweist, sowie ein Verfahren zum Steuern zumindest einer Fahrzeugfunktion mittels des Sitzbezugs 1 in gemeinsamer Beschreibung dargelegt. Dabei sind gleiche und funktionsgleiche Elemente in den Figuren mit gleichen Bezugszeichen versehen.

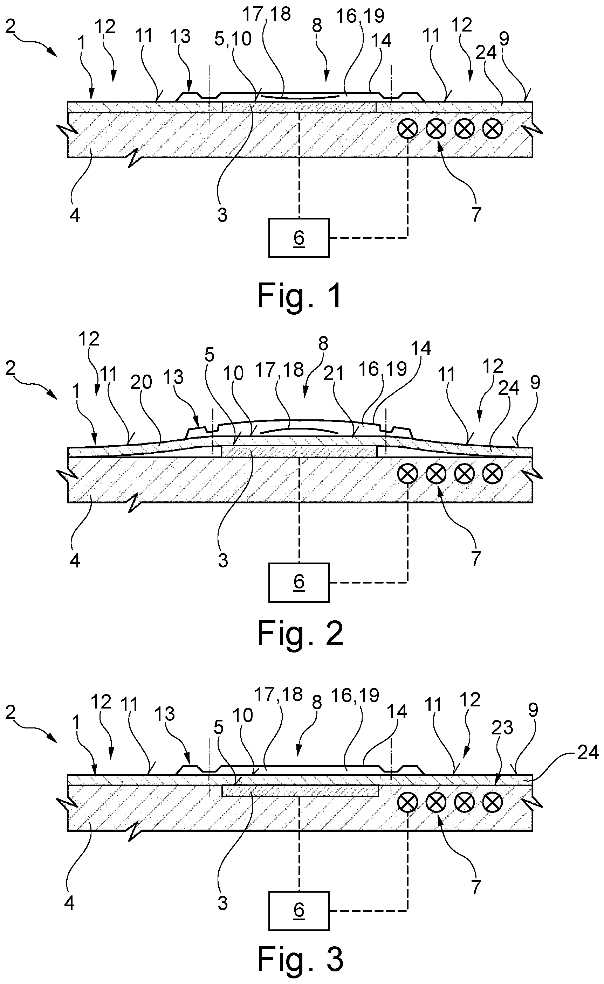

Fig. 1 zeigt eine schematische und geschnittene Ansicht des Sitzelements 2, das einen nicht zur beanspruchten Erfindung gehörenden Sitzbezug 1 mit einem elektronischen Steuerungselement 3 aufweist. Durch das Sitzelement 2 ist in bestimmungsgemäßer Einbaulage eine Sitzanlage, insbesondere Sattelsitzanlage, des Kraftfahrzeugs bzw. Motorrads oder Kraftrads gebildet. Das bedeutet, das Motorrad weist das Sitzelement 2 und infolgedessen den Sitzbezug 1 als Bestandteil der Sitzanlage auf. Dabei handelt es sich bei dem Sitzelement 2 zum Beispiel um ein Sitzkissen oder um eine Rückenlehne. Ferner kann es sich bei dem Sitzelement 2 um ein Sattelsitzelement handeln, auf welchem ein Nutzer der entsprechenden Sitzanlage rittlings sitzt.

Der Sitzbezug 1 kann eine Polsterung 4 aufweisen und weist jedenfalls das elektronischen Steuerungselement 3 auf, welches seinerseits eine berührungssensitive, vorliegend kapazitive Sensoroberfläche 5 aufweist. Das Steuerungselement 3 ist in bestimmungsgemäßer Einbaulage (das heißt, wenn das das Sitzelement 2 aufweisende Kraftfahrzeug bzw. Motorrad einsatzbereit hergestellt ist), mit einer Steuereinrichtung 6 des Kraftfahrzeugskabellos oder kabelgebunden verbunden. Mittels der Steuereinrichtung 6 ist eine Fahrzeugfunktion, vorliegend am Beispiel einer Sitzheizung 7 dargelegt, steuerbar bzw. regelbar. Hierzu sind die Steuereinrichtung 6 und die Sitzheizung 7 zur Steuersignalübertragung miteinander gekoppelt. Die Sitzheizung 7 ist dazu ausgebildet, ein mittels der Steuereinrichtung 6 bereitgestelltes oder zugestelltes Steuersignal als Eingangssteuersignal zu akzeptieren.

Der Sitzbezug 1 weist einen Betätigungsanteil 8 auf, sodass eine gesamte Außenoberfläche 9 des Sitzbezugs 1 durch einen ersten Außenoberflächenanteil 10 des Betätigungsanteils 8 und einen zweiten Außenoberflächenanteil 11 eines von dem Betätigungsanteil 8 verschiedenen restlichen Anteils 12 bzw. Nichtbetätigungsanteils 12 des Sitzbezugs 1 gebildet ist. Gemäß Fig. 1 ist in einem möglichen Ausführungsbeispiel der erste Außenoberflächenanteil 10 des Betätigungsanteils 8 durch die Sensoroberfläche 5 gebildet.

Durch Ausführen einer Betätigungshandlung, die ein Nutzer an/in dem ersten Außenoberflächenanteil 10, das heißt an/in dem Anteil der Außenoberfläche 9 des Sitzbezugs, der durch den Betätigungsanteil 8 gebildet ist, vornimmt, etwa ein Einfach- oder Mehrfachantippen, Streichen, Wischen etc., wird die Sensoroberfläche 5 durch den Nutzer betätigt, da die Sensoroberfläche 5 funktional dem Betätigungsanteil 8 des Sitzbezugs 1 zugeordnet ist. Hierdurch wird der Steuereinrichtung 6 des Kraftfahrzeugs mittels des Steuerungselements 3 basierend auf der Nutzereingabe ein Steuersignal bereitgestellt, anhand dessen die Fahrzeugfunktion, beispielsweise die Sitzheizung 7 gesteuert wird. So kann der Sitzbezug 1 in Verbindung mit dem Steuerungselement 3 dazu eingesetzt werden, die Fahrzeugfunktion (etwa die Sitzheizung 7) zwischen einem aktivierten Zustand und einem deaktivierten Zustand umzuschalten. Ebenso kann mittels des Sitzbezugs 1 bzw. mittels des Steuerungselements 3 eine Betriebsstufe bzw. Intensität der Fahrzeugfunktion (beispielsweise der Sitzheizung 7) eingestellt werden.

In Fig. 1 ist des Weiteren dargestellt, dass der Betätigungsanteil 8 und der restliche Anteil 12 bzw. Nichtbetätigungsanteil 12 des Sitzbezugs 1 spaltfrei aneinanderstoßen und insbesondere spaltfrei miteinander verbunden sind. Mit anderen Worten ist der Sitzbezug 1 derart ausgebildet, dass dessen gesamte Außenoberfläche 9 spaltfrei ist.

Zudem zeigt Fig. 1 eine Markierungsanordnung 13, die positionell mit dem Betätigungsanteil 8 korrespondiert. Vorliegend bedeutet das, dass durch die Markierungsanordnung 13 eine positionelle Lage des Betätigungsanteils 8 an der Außenoberfläche 9 des Sitzbezugs 1 gekennzeichnet/markiert ist. Denn die Markierungsanordnung 13 ist an/auf der Außenoberfläche 9 angeordnet bzw. ausgebildet oder bildet diese zumindest teilweise. Dabei weist die Markierungsanordnung 13 eines oder mehr der folgenden Markierungselemente 14 auf: eine Farbmarkierung, eine Prägung, ein Stickgebilde, ein Nähgebilde, ein Markierungsbezugelement (das sich optisch und/oder haptisch von dem Sitzbezugelement unterscheidet) etc. Vorliegend weist die Markierungsanordnung 13 eine biegsame oder biegeschlaffe oder starre Plakette ("Badge") 15 auf, die kraft-, form- und/oder stoffschlüssig mit der Außenoberfläche 9 verbunden ist. Zum Beispiel kann vorgesehen sein, dass die Plakette 15 auf die Außenoberfläche 9 des Sitzbezugs 1 aufgeschweißt, aufgenietet, aufgenäht, aufgeklebt etc. ist. Zudem kann die Markierungsanordnung 13 ein Leuchtelement 16 (zum Beispiel eine LED, eine Leuchtfolie, eine Leuchtfaser, einen Leuchtfaden etc.) aufweisen. Das Leuchtelement 16 kann als ein aktives elektrisches und/oder elektronisches Bauelement ausgeführt sein oder als ein passiv Licht emittierendes Bauelement (zum Beispiel als phosphoreszierendes oder fluoreszierendes Element).

Durch die Markierungsanordnung 13 kann ein länglicher Betätigungspfad (nicht dargestellt), an dem der Nutzer zum Steuern der Fahrzeugfunktion seinen Finger bzw. seine Fingerspitze - den ersten Außenoberflächenanteil 10 berührend - entlangführt, haptisch und/oder optisch hervorgehoben bzw. markiert sein. Anders ausgedrückt: Kommt zum Steuern/Regeln der Fahrzeugfunktion eine Wisch- oder Streichgeste des Nutzers infrage, kann der Pfad, entlang dessen die Wisch- oder Streichgeste auszuführen ist, um die Fahrzeugfunktion zu steuern/regeln, mittels der Markierungsanordnung 13, insbesondere durch das Leuchtelement 16, hervorgehoben sein.

Der Sitzbezug 1 weist ferner eine Kontrolleinrichtung 17 auf, mittels derer dem Nutzer über den Betätigungsanteil ein Kontrollsignal bereitgestellt wird, das eine erfolgreiche Betätigung der Sensoroberfläche 5 charakterisiert. Dabei kann die Kontrolleinrichtung 17 zumindest teilweise in die Markierungsanordnung 13 integriert sein. Im vorliegenden Beispiel weist die Kontrolleinrichtung 17 ein als eine Schnappscheibe ausgebildetes Federelement 18 auf, das unter einem Betätigen der Sensoroberfläche 5 ein Kontrollgeräusch abgibt und so dem Nutzer eine haptische und optische Rückmeldung bereitstellt. Das Federelement 18 kann in alternativer Ausgestaltung (in den Figuren nicht dargestellt) durch elastisch reversibel verformbare Wandungen von Hohlräumen gebildet sein, mit denen einen Materialkörper, etwa aus einem Elastomer, zum Beispiel einen Materialkörper der Markierungsanordnung 13 durchsetzt ist. Bei einem Komprimieren des Materialkörpers werden die Wandungen der Hohlräume unter Abgabe des Knackgeräusches verformt.

Des Weiteren weist die Kontrolleinrichtung 17 vorliegend eine Leuchteinheit 19 auf, welche basierend auf einem Betätigen der Sensoroberfläche 5 ein Kontrolllichtsignal ausgibt oder ein bestehendes Kontrolllichtsignal ändert. Es kann dabei vorgesehen sein, dass die Leuchteinheit 19 als wenigstens ein Leuchtmittel das Leuchtelement 16 aufweist.

Fig. 2 zeigt eine schematische und geschnittene Ansicht des Sitzelements 2, wobei der erfindungsgemäße Sitzbezug 1 eine Sitzbezugsschicht 20 aufweist, mit der die Sensoroberfläche 5 des Steuerungselements 3 bedeckt ist. Die Sitzbezugsschicht 20 weist eine Oberseite 21 und eine Rückseite 22 auf, die voneinander wegweisen und über eine Stärke/Dicke der Sitzbezugsschicht 20 voneinander beabstandet sind. Durch die Oberseite 21 ist zumindest der erste Außenoberflächenanteil 10 des Sitzbezugs 1 gebildet. Dabei ist die Sitzbezugsschicht 20 im Betätigungsanteil 8 elektrisch leitfähig ausgebildet, sodass zumindest zwischen einem im Betätigungsanteil 8 angeordneten Anteil der Oberseite 21 und einem im Betätigungsanteil 8 angeordneten Anteil der Rückseite 22 eine elektrisch leitende/leitfähige Verbindung hergestellt ist. Die Sensoroberfläche 5 grenzt dabei im Betätigungsanteil 8 - vorliegend direkt - an die Rückseite 22 an und ist an dieser insbesondere fixiert. So kann der Nutzer durch die Sitzbezugsschicht 20 hindurch die Sensoroberfläche 5 betätigen, also die Sitzbezugsschicht 20 hindurch die Fahrzeugfunktion, insbesondere die Sitzheizung 7, wunschgemäß einstellen bzw. bedienen. Demgemäß ist das elektronische Steuerungselement 3 insoweit mit der Sitzbezugsschicht 20 bezogen oder überspannt, als die Sensoroberfläche 5 von der Sitzbezugsschicht 20 überdeckt ist. So ergibt sich in vorteilhafter Weise eine spaltfreie, insbesondere nahtlose Struktur der Außenoberfläche 9, die in diesem Fall durch die Sitzbezugsschicht 20 gebildet ist.

Fig. 3 eine schematische und geschnittene Ansicht des Sitzelements 2, wobei das Steuerungselement 3 teilweise in die Polsterung 4 eingebettet ist. Auf diese Weise ergibt sich eine besonders flache Gestalt des Sitzbezugs 1. Bei der Polsterung 4 kann es sich um eine Polsterung des Sitzelements 2 handeln. Vorliegend handelt es sich bei der Polsterung 4 um einen Bestandteil des Sitzbezugs 1.

Anhand Fig. 3 wird ein nicht zur beanspruchten Erfindung gehörendes Sitzelement 2 erklärt, bei dem der restliche Anteil 12 des Sitzbezugs 1 durch eine Polsterungsoberfläche 23 der Polsterung 4 gebildet ist, wobei die Sensoroberfläche 5 und die Polsterungsoberfläche 23 bündig und spaltfrei miteinander abschließen. Das bedeutet, dass eine lediglich beispielhaft dargestellte und auf der Polsterung 4 angeordnete Bezugstoffschicht 24, zum Beispiel Leder, Kunstleder, Textil etc., im Unterschied zu den anderen Ausführungsformen entfallen kann, falls diese eine solche Bezugstoffschicht 24 aufweisen. Dabei ist durch die Polsterungsoberfläche 23 die gesamte Außenoberfläche 9 des Sitzbezugs 1 gebildet. Insoweit ist der Ausdruck "Sitzbezug" hierin generell auch so zu verstehen, dass es sich bei dem Sitzbezug 1 um eine letzte äußerstliegende Schicht des Sitzelements 2 handeln kann.

Insgesamt ist durch den Sitzbezug 1, durch das Sitzelement 2 sowie durch das Kraftfahrzeug bzw. Motorrad eine jeweilige Möglichkeit aufgezeigt, ein Bedienelement (vorliegend das Steuerungselement 3) zum Steuern einer Fahrzeugfunktion (beispielsweise der Sitzheizung 7) besonders effizient in eine Sitzanlage des Fahrzeugs, insbesondere des Motorrads oder des Kraftwagens zu integrieren. Dabei kann der erste Außenoberflächenanteil 10 in Bezug auf ein bestimmungsgemäß auf einen Untergrund aufgestelltes Kraftfahrzeug nach oben, nach rechts, nach links oder nach unten weisen. Es ist weiter zu verstehen, dass das Kraftfahrzeug wenigstens ein weiteres Sitzelement 2 aufweisen kann. Dabei kann das jeweilige Sitzelement 2 zumindest ein weiteres Steuerungselement 3 aufweisen.

Ein herkömmlicher Übergang zwischen einer herkömmlichen Schaltervorrichtung und der Außenoberfläche 9 des Sitzbezugs 1 wird durch die Erfindung wunschgemäß vermieden. Insbesondere wird auf eine extra Blende aus Kunststoff oder eine Schalterkonsole aus Kunststoff - jeweils meist als aufwändiges, schwarzes und genarbtes Spritzgießbauteil ausgebildet - verzichtet. Ein aufwändiges passgenaues Ausrichten eines solchen Kunststoffbauteils entfällt in vorteilhafter Weise. Über den Sitzbezug 1 überstehende Bauteilkanten Löcher und Lücken zwischen der Blende und der Außenoberfläche 9 sind ebenso vermieden, wie ein (zum Beispiel alterungsbedingtes) Verziehen/Verformen der Blende. Durch den nun spaltfreien Sitzbezug 1 fügt sich die Bedienungsfunktionalität zum Bedienen der wenigstens einen Fahrzeugfunktion mittels des Steuerungselements 3 besonders gefällig in das Gesamtbild der Motorradsitzbank ein.

Es werden dünne flache Leiterbahnen und kapazitive Signale zum Schalten bzw. Steuern der Fahrzeugfunktion, insbesondere der Sitzheizung 7, verwendet. Die Signale werden von einer zentralen Fahrzeugelektronik, insbesondere mittels der Steuereinrichtung 6, verarbeitet und zum Schalten/Steuern der Sitzheizung 7 ausgewertet und weiterverarbeitet. Die Leiterbahnen und kapazitive Empfängerelemente, insbesondere die Sensoroberfläche 5, werden in den Sitzbezug 1 unsichtbar integriert. Um dem Motorradfahrer auch ein haptisches Feedback zu geben, sind fühlbare/ertastbare Elemente notwendig, die vorliegend durch haptisch wirksame - also erhabene und/oder vertiefte - Markierungselemente 14 realisiert werden. Für eine besonders stark fühlbare haptische Rückmeldung kann das Federelement 18 eingesetzt werden (ähnlich einem Knackfrosch). So ist eine Möglichkeit bereitgestellt, dem Fahrer selbst durch dicke Motorradschutzkleidung, wie Handschuhe, hindurch die haptische Rückmeldung zuverlässig zuzustellen. Bei entsprechender Einsehbarkeit sind auch aktiv oder passiv leuchtende Elemente möglich, die auf die Außenoberfläche 9 des Sitzbezugs 1 appliziert oder damit vernäht sind. Dem Fahrer kann somit eine optische Rückmeldung über den Schaltzustand der Fahrzeugfunktion bzw. Sitzheizung 7 gegeben werden.

### Bezugszeichenliste

- 1: Sitzbezug
- 2: Sitzelement
- 3: elektronisches Steuerungselement
- 4: Polsterung
- 5: Sensoroberfläche
- 6: Steuereinrichtung
- 7: Sitzheizung
- 8: Betätigungsanteil
- 9: Außenoberfläche
- 10: erster Außenoberflächenanteil
- 11: zweiter Außenoberflächenanteil
- 12: Nichtbetätigungsanteil / restlicher Anteil des Sitzbezugs
- 13: Markierungsanordnung
- 14: Markierungselement
- 15: Plakette
- 16: Leuchtelement
- 17: Kontrolleinrichtung
- 18: Federelement
- 19: Leuchteinheit
- 20: Sitzbezugsschicht
- 21: Oberseite
- 22: Rückseite
- 23: Polsterungsoberfläche
- 24: Bezugstoffschicht

## Patentansprüche

1. Sitzbezug (1) für ein Sitzelement (2) eines Kraftfahrzeugs, wobei der Sitzbezug (1) ein elektronisches Steuerungselement (3) mit einer berührungssensitiven Sensoroberfläche (5) aufweist, das dazu ausgebildet ist, mit einer Steuereinrichtung (6) des Kraftfahrzeugs zum Steuern einer Fahrzeugfunktion (7) gekoppelt zu werden, und dazu, aufgrund einer Betätigungshandlung, die ein Nutzer an einem Außenoberflächenanteil (10) eines vorgegebenen Betätigungsanteils (8) des Sitzbezugs (1) vornimmt, wodurch die berührungssensitive Sensoroberfläche (5) betätigt wird, ein Steuersignal bereitzustellen, wobei der Betätigungsanteil (8) und ein restlicher Anteil (12) des Sitzbezugs (1) spaltfrei miteinander verbunden sind. **dadurch gekennzeichnet, dass** eine Sitzbezugsschicht (20), durch deren Oberseite (21) der Außenoberflächenanteil (10) des Betätigungsanteils (8) gebildet ist, im Betätigungsanteil (8) elektrisch leitfähig ausgebildet ist, und wobei die Sensoroberfläche (5) an einer der Oberseite (21) gegenüberliegenden Rückseite (22) der Sitzbezugsschicht (20) gegenüber dem Betätigungsanteil (8) angeordnet ist.

2. Sitzbezug (1) nach Anspruch 1,
**gekennzeichnet durch**
eine positionell mit dem Betätigungsanteil (8) korrespondierende Markierungsanordnung (13), die eines oder mehr der folgenden Markierungselemente (14) aufweist:
- eine Farbmarkierung,
- eine Prägung,
- ein Stickgebilde,
- ein Nähgebilde,
- ein Markierungsbezugelement,
- eine Plakette (15),
- ein Leuchtelement (16).

3. Sitzbezug (1) nach Anspruch 2,
**dadurch gekennzeichnet, dass**
durch die Markierungsanordnung (13) ein Betätigungspfad an dem Außenoberflächenanteil (10) gekennzeichnet ist.

4. Sitzbezug (1) nach einem der vorhergehenden Ansprüche,
**gekennzeichnet durch**
eine Kontrolleinrichtung (17), die dazu ausgebildet ist, mittels des Betätigungsanteils (8) ein Kontrollsignal bereitzustellen, das eine erfolgreiche Betätigung der Sensoroberfläche (5) charakterisiert.

5. Sitzbezug (1) nach Anspruch 4,
**dadurch gekennzeichnet, dass**
die Kontrolleinrichtung (17) ein Federelement (18) aufweist, das unter einem Betätigen der Sensoroberfläche (5) ein Kontrollgeräusch abgibt und dabei eine haptische Rückmeldung bereitstellt.

6. Sitzbezug (1) nach Anspruch 4 oder 5,
**dadurch gekennzeichnet, dass**
die Kontrolleinrichtung (17) eine Leuchteinheit (19) aufweist, die dazu ausgebildet ist, basierend auf einem Betätigen der Sensoroberfläche (5) ein Kontrolllichtsignal auszugeben und/oder zu ändern.

7. Sitzelement (2) für ein Kraftfahrzeug, mit einer Polsterung (4), die mit einem gemäß einem der vorhergehenden Ansprüche ausgebildeten Sitzbezug (1) bezogen ist.

8. Kraftfahrzeug mit einem nach Anspruch 7 ausgebildeten Sitzelement (2), wobei das elektronische Steuerelement (3) und eine Steuereinrichtung (6) des Kraftfahrzeugs zum Steuern einer Fahrzeugfunktion (7) miteinander gekoppelt oder koppelbar sind.

## Claims

1. Seat cover (1) for a seat element (2) of a motor vehicle, wherein the seat cover (1) comprises an electronic control element (3) with a touch-sensitive sensor surface (5) that is designed to be coupled to a control device (6) of the motor vehicle for controlling a vehicle function (7), and to provide a control signal based on an actuation action that a user performs on an outer surface portion (10) of a predetermined actuation portion (8) of the seat cover (1), whereby the touch-sensitive sensor surface (5) is actuated, wherein the actuation portion (8) and a remaining portion (12) of the seat cover (1) are connected to each other without a gap,
**characterized in that**
a seat cover layer (20), whose upper side (21) forms the outer surface portion (10) of the actuation portion (8), is electrically conductive in the actuation portion (8), and wherein the sensor surface (5) is arranged opposite the actuation portion (8) on a rear side (22) of the seat cover layer (20) opposite to the upper side (21).

2. Seat cover (1) according to claim 1,
**characterized by**
a marking arrangement (13) positionally corresponding to the actuation portion (8), which comprises one or more of the following marking elements (14):
• a color marking,
• an embossing,
• an embroidery,
• a stitching,
• a marking cover element,
• a plaque (15),
• a light element (16).

3. Seat cover (1) according to claim 2,
**characterized in that**
an actuation path is marked on the outer surface portion (10) by the marking arrangement (13).

4. Seat cover (1) according to any one of the preceding claims,
**characterized by**
a control device (17) that is designed to provide a control signal by means of the actuation portion (8), which characterizes a successful actuation of the sensor surface (5).

5. Seat cover (1) according to claim 4,
**characterized in that**
the control device (17) comprises a spring element (18) that emits a control sound when the sensor surface (5) is actuated and thereby provides haptic feedback.

6. Seat cover (1) according to claim 4 or 5,
**characterized in that**
the control device (17) comprises a light unit (19) that is designed to output and/or change a control light signal based on an actuation of the sensor surface (5).

7. Seat element (2) for a motor vehicle, with a padding (4) that is covered with a seat cover (1) designed according to any one of the preceding claims.

8. Motor vehicle with a seat element (2) designed according to claim 7, wherein the electronic control element (3) and a control device (6) of the motor vehicle are coupled or can be coupled to control a vehicle function (7).

## Revendications

1. Housse de siège (1) pour un élément de siège (2) d'un véhicule automobile, la housse de siège (1) comprenant un élément de commande électronique (3) avec une surface de capteur tactile (5) conçue pour être couplée à un dispositif de commande (6) du véhicule automobile pour commander une fonction du véhicule (7), et pour fournir un signal de commande basé sur une action d'actionnement qu'un utilisateur effectue sur une partie de surface extérieure (10) d'une partie d'actionnement prédéterminée (8) de la housse de siège (1), par laquelle la surface de capteur tactile (5) est actionnée, la partie d'actionnement (8) et une partie restante (12) de la housse de siège (1) étant reliées l'une à l'autre sans interstice,
**caractérisée en ce que**
une couche de housse de siège (20), dont la face supérieure (21) forme la partie de surface extérieure (10) de la partie d'actionnement (8), est électriquement conductrice dans la partie d'actionnement (8), et la surface du capteur (5) est disposée en face de la partie d'actionnement (8) sur une face arrière (22) de la couche de housse de siège (20) opposée à la face supérieure (21).

2. Housse de siège (1) selon la revendication 1,
**caractérisée par**
un agencement de marquage (13) correspondant positionnellement à la partie d'actionnement (8), qui comprend un ou plusieurs des éléments de marquage (14) suivants :
• un marquage coloré,
• un gaufrage,
• une broderie,
• une couture,
• un élément de housse de marquage,
• une plaque (15),
• un élément lumineux (16).

3. Housse de siège (1) selon la revendication 2,
**caractérisée en ce que**
un chemin d'actionnement est marqué sur la partie de surface extérieure (10) par l'agencement de marquage (13).

4. Housse de siège (1) selon l'une quelconque des revendications précédentes,
**caractérisée par**
un dispositif de contrôle (17) conçu pour fournir un signal de contrôle au moyen de la partie d'actionnement (8), qui caractérise un actionnement réussi de la surface du capteur (5).

5. Housse de siège (1) selon la revendication 4,
**caractérisée en ce que**
le dispositif de contrôle (17) comprend un élément à ressort (18) qui émet un son de contrôle lors de l'actionnement de la surface du capteur (5) et fournit ainsi un retour haptique.

6. Housse de siège (1) selon la revendication 4 ou 5,
**caractérisée en ce que**
le dispositif de contrôle (17) comprend une unité lumineuse (19) conçue pour émettre et/ou modifier un signal lumineux de contrôle basé sur un actionnement de la surface du capteur (5).

7. Élément de siège (2) pour un véhicule automobile, avec un rembourrage (4) qui est recouvert d'une housse de siège (1) conçue selon l'une quelconque des revendications précédentes.

8. Véhicule automobile avec un élément de siège (2) conçu selon la revendication 7, dans lequel l'élément de commande électronique (3) et un dispositif de commande (6) du véhicule automobile sont couplés ou peuvent être couplés pour commander une fonction du véhicule (7).
